# EUROPÄISCHE PATENTSCHRIFT

(11) **EP 1 408 554 B1**
(45) Veröffentlichungstag und Bekanntmachung des Hinweises auf die Patenterteilung: **25.03.2015**
(21) Anmeldenummer: 03026265.3
(22) Anmeldetag: 30.01.1997
(51) Int. Cl.: H01L 29/78, H01L 29/739, H01L 29/06

(54) **Durch Feldeffekt steuerbares Halbleiterbauelement**
Field effect controlled semiconductor component
Composant semi-conducteur commandé par effet de champ

(30) Priorität: 05.02.1996 DE 19604043; 05.02.1996 DE 19604044
(43) Veröffentlichungstag der Anmeldung: 14.04.2004
(62) Teilanmeldung aus: 00112818.0
(73) Patentinhaber: Infineon Technologies AG, 85579 Neubiberg (DE)
(72) Erfinder: Tihanyi, Jenö, 85551 Kirchheim (DE); Strack, Helmut, 80804 München (DE); Geiger, Heinrich, 83607 Holzkirchen (DE)
(74) Vertreter: Westphal, Mussgnug & Partner Patentanwälte mbB

(56) Entgegenhaltungen:
- EP-A- 0 503 605
- DE-A1- 4 309 764
- US-A- 5 216 275

## Beschreibung

Die Erfindung betrifft ein durch Feldeffekt steuerbares Halbleiterbauelement bestehend aus einem Halbleiterkörper,
a) mit einer inneren Zone vom ersten Leitungstyp, die an eine der Oberflächen des Halbleiterkörpers angrenzt,
b) mit einer Drainzone, die an die Innenzone angrenzt,
c) mit mindestens einer Basiszone vom zweiten Leitungstyp, die in die besagte Oberfläche des Halbleiterkörpers eingebettet ist,
d) mit mindestens einer Sourcezone vom ersten Leitungstyp, welche in die Basiszone eingebettet ist,
e) mit mindestens einer Sourceelektrode, die jeweils eine Basiszone und die darin eingebetteten Sourcezonen kontaktiert und
f) mit einer gegen den gesamten Halbleiterkörper isolierten Gatelektrode.

Derartige vertikale durch Feldeffekt steuerbare Halbleiterbauelemente sind seit langem Stand der Technik. Zum einen sind sie als VMOS-Feldeffekttransistoren bekannt, sofern die Drainzone, die an die Innenzone angrenzt, vom selben Leitungstyp wie die Innenzone ist. Zum anderen sind solche durch Feldeffekt steuerbare Halbleiterbauelemente als IGBTs bekannt, sofern die Drainzone als Anodenzone ausgebildet ist und vom entgegengesetzten Leitungstyp ist wie die Innenzone.

Weitere durch Feldeffekt steuerbare Halbleiterbauelemente bestehen aus einem Halbleiterkörper vom ersten Leitungstyp,
a) mit einer Sourcezone und einer Drainzone vom zweiten Leitungstyp, die räumlich voneinander getrennt sind und jeweils mit einer Sourceelektrode und einer Drainelektrode versehen sind,
b) mit einer zwischen der Sourcezone und der Drainzone liegenden und an die Drainzone angrenzenden Driftzone vom zweiten Leitungstyp, und
c) mit einer gegen die Oberfläche des Halbleiterkörpers isolierten Gateelektrode, die die Sourcezone und die Driftzone teilweise überdeckt.

Solche lateralen durch Feldeffekt steuerbare Halbleiterbauelemente sind seit langer Zeit als laterale MOSFETs bekannt.

Die eingangs genannten Halbleiterbauelemente sind ausführlich in dem Buch Jens Peer Stengl; Jenö Tihanyi: Leistungs-MOS-FET-Praxis, 2. Auflage, Pflaumverlag, München, 1992 erörtert.

Allen eingangs genannten Halbleiterbauelementen ist der Nachteil inhärent, daß der Durchlaßwiderstand Rₒₙ der Drain-Source-Laststrecke mit zunehmender Spannungsfestigkeit des Halbleiterbauelements zunimmt, da die Dicke der Innenzone bzw. der Driftzone zunehmen muß. Bei VMOS-MOSFETs liegt bei einer Spannung von 50 V der flächenbezogene Durchlaßwiderstand Rₒₙ bei ungefähr 0,20 Ohm/m² und steigt bei einer Sperrspannung von 1000 V beispielsweise auf einen Wert von ca. 10 Ohm/m² an.

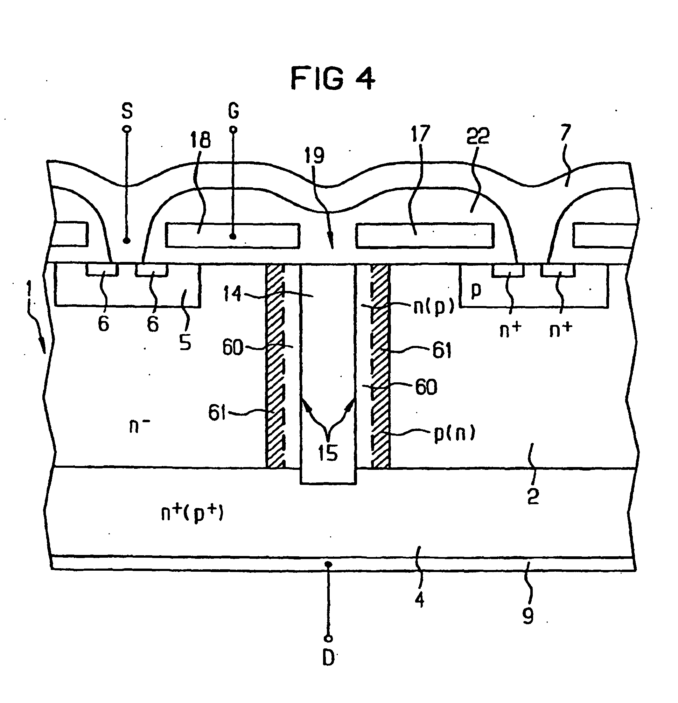

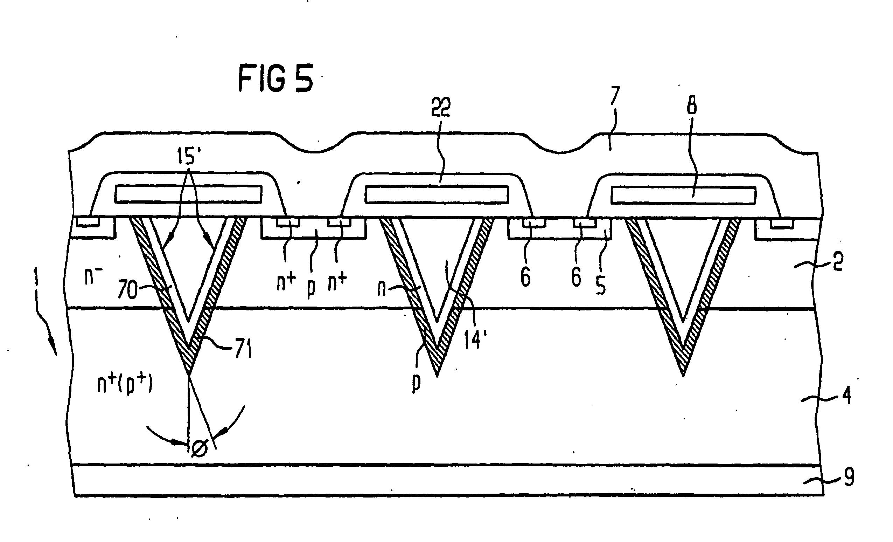

Um diesen Nachteil zu beseitigen, wird in der US 5,216,275 ein vertikaler MOSFET vorgestellt, bei dem statt einer homogenen beispielsweise epitaktisch aufgewachsenen Innenzone alternierend Schichten vom ersten und vom zweiten Leitungstyp vorliegen. Der prinzipielle Aufbau ist dort insbesondere in den Figuren 4 und 5 sowie den dazu gehörigen Teilen der Beschreibung aufgezeigt. Insbesondere werden dort die abwechselnden p- und n-Schichten jeweils mit den Basiszonen und den Drainzonen verbunden. Dies führt jedoch zu einer starken Einschränkung im Design eines Halbleiterbauelements, da die Randbereiche nicht mehr frei gestaltet werden können.

Die EP 0 503 605 A2 beschreibt einen vertikalen IGBT mit einer Anzahl von Transistorzellen, die jeweils eine Basiszone bzw. Bodyzone aufweisen und mit Guard-Ringen in einem Randbereich des Halbleiterbauelemente. Die Bodyzonen und die Guard-Ringe besitzen bei diesem Bauelement eine gleiche Dotierungskonzentration.

Aufgabe der vorliegenden Erfindung ist es daher, die eingangs genannten vertikalen durch Feldeffekt steuerbaren Halbleiterbauelemente so weiterzubilden, daß trotz hoher Sperrspannung ein niedriger Durchlaßwiderstand vorliegt und die im Stand der Technik aufgezeigten Nachteile beseitigt werden.

Die Erfindung betrifft ein vertikales Leistungs-Halbleiterbauelement der eingangs genannten Art, bei dem in der Innenzone eine oder mehrere Ausräumzonen vom zweiten Leitungstyp und eine oder mehrere Komplementärausräumzonen vom ersten Leitungstyp vorgesehen sind,
wobei die Gesamtmenge der Dotierung der Ausräumzonen in etwa der Gesamtmenge der Dotierung der Komplementärausräumzonen entspricht und wobei im Randbereich des Haibleiterkörpers wenigstens eine Ausräumzone angeordnet ist, die schwächer dotiert ist als die mindestens eine Ausräumzone in der Innenzone, und im Randbereich wenigstens eine Komplementärausräumzone angeordnet ist, die schwächer dotiert ist als die mindestens eine Komplementärausräumzone in der Innenzone.

Die Erfindung weist den Vorteil auf, daß durch einfaches Einbringen von -bei V-MOSFETs und IGBTs vorzugsweise gepaarten-Ausräumzonen und Komplementärausräumzonen, insbesondere entlang des Strompfades, zum einen durch die Komplementärausräumzonen eine gute Leitfähigkeit gewährleistet wird und sich zum anderen bei Erhöhung der Drainspannung diese Bereiche gegenseitig ausräumen, wodurch eine hohe Sperrspannung gesichert bleibt.

Liegt an den so ausgebildeten Halbleiterbauelementen eine Sperrspannung an, so bildet sich ausgehend vom pn-Übergang zwischen der Innenzone und der oder den Basiszonen bei den vertikalen Halbleiterbauelementen eine Raumladungszone aus, deren Ausdehnung mit steigender Sperrspannung wächst. Stößt die Raumladungszone an die Ausräumzonen an, so werden diese über das ausgeräumte Gebiet der Innenzone hochohmig an die Basiszonen angeschlossen. Bei weitersteigender Sperrspannung dehnt sich die Raumladungszone weiter aus, so daß auch ein Teil der Ladungsträger aus den Ausräumzonen und Komplementärausräumzonen ausgeräumt wird. Bei weiterer Steigerung der Sperrspannung sind dann die Ladungsträger aus einem großen Teil der Innenzone und aus den Ausräumzonen und Komplementärausräumzonen vollständig ausgeräumt. Die Raumladungszone wird dadurch in Richtung der Drain- bzw. der Anodenzone verlagert. Bei maximal anliegender Spannung liegen die Ausräumzonen und die Komplementärausräumzonen vollständig in der Raumladungszone. Analog dazu ist die Funktion der Ausräumzonen und Komplementärausräumzonen bei den lateralen MOSFETs.

Da die Gesamtmenge an Dotierung in den Ausräumzonen in etwa der Gesamtmenge an Dotierung in den Komplementärausräumzonen entspricht, wird gewährleistet, daß bei Erhöhung der Drainspannung die derart gebildeten p--n-Bereiche sich gegenseitig vollständig ausräumen, d.h. wie eine einzige Isolatorzone verhalten, wodurch eine hohe Sperrspannung gesichert bleibt.

In einer Ausführungsform der vorliegenden Erfindung sind die Ausräumzone und die Komplementärausräumzone in der Innenzone jeweils paarweise angeordnet. Typischerweise weisen dann die paarweise eingebrachten Ausräumzonen und Komplementärausräumzonen in der Innenzone einen Abstand voneinander größer oder gleich 0 und kleiner oder gleich der Breite der Raumladungszone auf.

In einer alternativen Ausführung ist in die Innenzone eine einzige Komplementärausräumzone eingebracht, in die eine Vielzahl von Ausräumzonen eingebracht sind, wobei dann typischerweise der Abstand der Ausräumzonen innerhalb der Komplementärausräumzone zueinander kleiner gleich der Breite der Raumladungszone zwischen der Ausräumzone und der Komplementärausräumzone ist.

Bei dieser Ausführungsform können die in die Komplementärausräumzone eingebrachten Ausräumzonen in etwa kugelförmige, quaderförmige oder irreguläre Gestalt aufweisen.

Zweckmäßigerweise entspricht in einer Weiterbildung dieser alternativen Ausführungsform die Komplementärausräumzone der gesamten Innenzone.

Schließlich wird noch ein Verfahren zum Herstellen von paarweise angeordnetenAusräumzonen/Komplementärausräumzonen angegeben. Dabei wird auf ein Substrat eine erste Epitaxieschicht aufgebracht, die p-Dotierstoffe und n-Dotierstoffe in etwa gleichen Mengen enthält, wobei die Diffusionskoeffizienten der beiden Dotierelemente sich deutlich voneinander unterscheiden. In die erste Epitaxieschicht werden danach Gräben geätzt und diese Gräben werden mit einer zweiten hochohmigen Epitaxieschicht aufgefüllt. Das so prozessierte Substrat wird daraufhin einem Temperschritt unterworfen, bei dem die beiden unterschiedlich schnell diffundierenden Dotierelemente der ersten Epitaxieschicht in die zweite Epitaxieschicht eindiffundieren können. Aufgrund des unterschiedlichen Diffusionsverhaltens bilden sich danach paarweise Ausräumzonen und Komplementärausräumzonen an den Grabenrändern aus.

Die Erfindung ist in der Zeichnung beispielsweise veranschaulicht und im folgenden anhand der Zeichnung beschrieben.

Es zeigen:
- Figur 1: einen Teilschnitt durch einen erfindungsgemäßen Vertikal-MOSFET der -in entsprechend mit A, B, C gekennzeichneten Bereichen- verschiedene Realisierungsmöglichkeiten aufzeigt,
- Figur 2: einen Teilschnitt durch einen alternativen erfindungsgemäßen V-MOSFET,
- Figur 3: einen Teilschnitt durch einen weiteren erfindungsgemäßen V-MOSFET mit einer Grabenstruktur,
- Figur 4: einen Teilschnitt durch einen weiteren erfindungsgemäßen V-MOSFET mit Grabenstruktur,
- Figur 5: einen Teilschnitt durch einen erfindungsgemäßen V-MOSFET mit V-förmiger Grabenstruktur,
- Figur 6: einen Teilschnitt durch einen lateralen MOSFET,
- Figur 7a bis 7d: zeigen jeweils teilweise Schnitte, anhand derer die charakteristischen Verfahrensschritte zur Herstellung eines erfindungsgemäßen vertikalen MOSFET gezeigt werden,
- Figur 8a bis 8b: jeweils teilweise Schnitte anhand derer alternative Verfahrensschritte zur Herstellung eines erfindungsgemäßen vertikalen MOSFET gezeigt werden, und

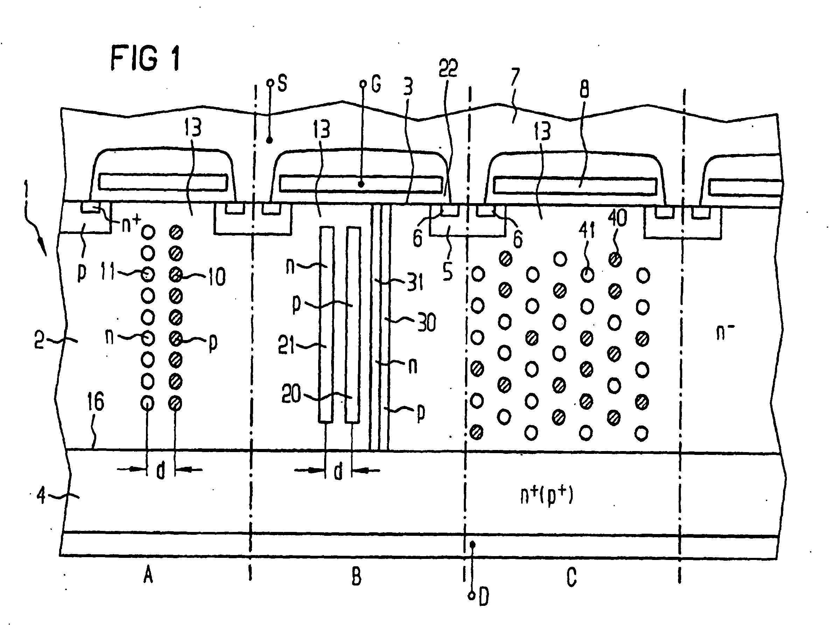

In den Figuren 1 bis 5 ist der Halbleiterkörper des Halbleiterbauelements mit 1 bezeichnet. Er hat eine sourceseitige Oberfläche 3 und eine drainseitige Oberfläche 16. Er weist eine n--dotierte Innenzone 2 auf, die an die Oberfläche 3 des Halbleiterkörpers 1 angrenzt. In die Oberfläche 3 sind mehrere Basiszonen 5 eingebettet. Diese Basiszonen 5 weisen zellenförmige Strukturen auf. Solche Zellenstrukturen können streifenförmig, sechseckig, dreieckig, rund oder viereckig sein. Die Basiszonen 5 haben den der Innenzone 2 entgegengesetzten Leitungstyp, d.h. sie sind im gezeigten Fall p-dotiert. In die Basiszonen 5 sind jeweils zwei stark n-dotierte Sourcezonen 6 eingebettet. Die Basiszonen 5 und die Sourcezonen 6 sind von Sourceelektroden 7 kontaktiert, die aus Metall, beispielsweise Aluminium bestehen.

An die andere Seite der Innenzone 2 grenzt eine stark n-dotierte Drainzone 4, bzw. im Fall eines IGBTs eine stark p-dotierte Anodenzone an. Diese ist über eine Metallisierung mit einer Drainelektrode 9 versehen.

Die Basiszonen 5 sind über Zwischenzellenzonen 13 räumlich voneinander getrennt.

Isoliert durch ein Gateoxid über der sourceseitigen Oberfläche 3 ist eine Gateelektrode 8 angeordnet. Die Gateelektrode 8 kann aus hochdotiertem Polysilizium bzw. aus Metall bestehen.

In Figur 1 werden verschiedene Ausführungsformen der vorliegenden Erfindung der Übersichtlichkeit halber in einer einzigen Figur gezeigt.

Figur 1 zeigt in den Zwischenzellenzonen 13 innerhalb der Innenzone 2 verschiedene Ausräumzonen, Komplementärausräumzonen 10, 11 bzw. 20, 21 bzw. 30, 31 bzw. 40, 41 eingebracht. Diese können miteinander in Kontakt stehen, d.h. sie können einander berühren, sie müssen einander jedoch nicht berühren. Sofern sie einander berühren, was bei der gezeigten Komplementärausräumzone 30 und der gezeigten Ausräumzone 31 der Fall ist, bilden sie einen pn-Übergang.

Alle gezeigten Ausräumzonen sind p-dotiert und alle gezeigten Komplementärausräumzonen sind n-dotiert. Die Ausräumzonen und Komplementärausräumzonen können, wie im Bereich A mit den Bezugszeichen 10, 11 dargestellt, kugelförmig ausgebildet sein und sich entlang des Strompfades der Drain-Source-Laststrecke erstrecken. Im Bereich B sind die Komplementärausräumzonen 21, 31 und Ausräumzonen 20, 30 fadenförmig bzw. streifenförmig ausgebildet. Dort sind die Ausräumzonen 20 und Komplementärausräumzonen 21 innerhalb der Innenzone 2 "floatend", d.h. frei schwebend, ausgeführt und füllen nur einen Teil der Innenzone 2 aus. Sie können aber auch -wie durch die Bezugszeichen 30, 31 angedeutet- von der sourceseitigen Oberfläche 3 bis zur drainseitigen Oberfläche 16 und/oder in die Drainzone 4 hineinreichen. Wie im Bereich B gezeigt, kann der Abstand d der Ausräumzonen und Komplementärausräumzonen zueinander größer oder gleich 0 sein.

Im Bereich C ist eine weitere Ausführungsform dargestellt, bei der eine statistische Verteilung der Ausräumzonen und Komplementärausräumzonen 40, 41 vorgesehen ist. Dabei kann die Gestalt der Ausräumzonen und Komplementärausräumzonen 40, 41 sowie auch die Dotierungsverteilung innerhalb der einzelnen Ausräumzonen bzw. Komplementärausräumzonen unregelmäßig sein.

Erfindungswesentlich ist, daß die Gesamtmenge der Dotierung der Ausräumzonen in etwa der Gesamtmenge der Dotierung der Komplementärausräumzonen entspricht. Ferner ist zu beachten, daß die Summe der Volumenausdehnungen der eingebrachten Ausräumzonen ungefähr gleich oder kleiner der der Komplementärausräumzonen ist.

Des weiteren sollte im Fall der Anordnung gemäß dem Bereich C die durchschnittliche Konzentration der verteilten Ausräumzonen in etwa gleich oder größer der der eingebrachten Komplementärausräumzonen sein.

Der Abstand d zwischen den einzelnen Ausräumzonen und Komplementärausräumzonen sollte vorzugsweise kleiner als die Breite der Raumladungszone zwischen den Komplementärausräumzonen und Ausräumzonen bei der Durchbruchsspannung zwischen den benachbarten Ausräumzonen und Komplementärausräumzonen sein. Der Abstand d kann aber wie im Bereich B gezeigt, auch zu 0 werden.

Nachfolgend wird die Funktionsweise der in Figur 1 gezeigten Strukturen näher erläutert.

Bei kleiner Drainspannung ist die Leitfähigkeit gut, da die Komplementärausräumzonen niederohmig sind. Wird die Drainspannung erhöht, werden bei moderater Spannung, z.B. einer Spannung kleiner 30 V, die Ausräumzonen bzw. Komplementärausräumzonen gegenseitig ausgeräumt. Bei einer weiteren Spannungserhöhung wird nun die vertikale Feldstärke weiter erhöht und die Innenzone 2 nimmt die Spannung auf.

### Im einzelnen erfolgt dieser Vorgang folgendermaßen:

Die Ausräumung startet von der sourceseitigen Oberfläche 3 unter der Gateelektrode 8 und in den Basiszonen 5 eingebetteten Sourcezonen 6. Sie schreitet dann in die Ausräumzonen bzw. die Komplementärausräumzonen voran. Wenn die Raumladungszone die ersten Ausräumzonen erreicht, bleiben diese Gebiete auf der Spannung, die das Potential der Raumladungszone erreicht hat. Dann wird die nächste Umgebung in Richtung der Drainzone 1 ausgeräumt. Dieser Vorgang wiederholt sich von Schicht zu Schicht. Auf diese Weise schreitet die Raumladungszone voran, bis die Zone unterhalb der eingebrachten Dotierungen innerhalb der Innenzone 2 erreicht wird. Insgesamt wird dann die Raumladungszone so aufgebaut, als ob die zusätzlich eingebrachten Ausräumzonen und Komplementärausräumzonen nicht vorhanden wären.

Die Spannungsfestigkeit wird dabei nur durch die Dicke der Innenzone 2 bestimmt. Somit kann die erfindungsgemäße Anordnung beide Erfordernisse erfüllen, nämlich einen niederohmigen Durchlaßwiderstand Rₒₙ bei gleichzeitig hoher Spannungsfestigkeit.

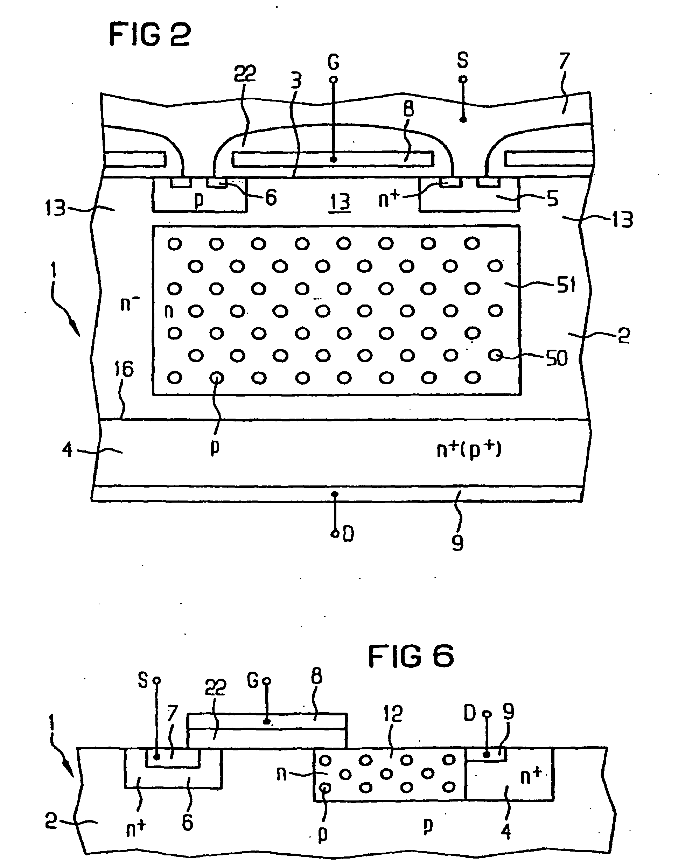

In der Figur 2 ist eine alternative Ausführungsform der vorliegenden Erfindung anhand eines V-MOSFETs gezeigt. Dort ist in eine n⁻-dotierte Innenzone 2 eine sich von den Zwischenzellenzonen 13 unter die Basiszonen 5 erstreckende n-dotierte Komplementärausräumzone 51 eingebracht. Innerhalb dieser Komplementärausräumzone 51 sind eine Vielzahl von p-dotierten Ausräumzonen 50 eingebracht. Die Verteilung dieser Ausräumzonen 50 kann statistisch oder regelmäßig sein. Die Ausräumzonen 50 können dabei eine beliebige Form aufweisen, wobei die in der Figur 2 gezeigten Ausräumzonen 50 eine in etwa kugelförmige Gestalt aufweisen. Auch hier ist die Gesamtmenge der Dotierungen in den verteilten Ausräumzonen 50 in etwa gleich der Gesamtmenge der Dotierungen in der n-dotierten Komplementärausräumzone 51. Ferner ist der Abstand zwischen den Ausräumzonen 50 kleiner als die Breite der Raumladungszone zwischen den Ausräumzonen 50 und der Komplementärausräumzone 51 bei der Durchbruchspannung zwischen den Ausräumzonen 50 und der Komplementärausräumzone 51.

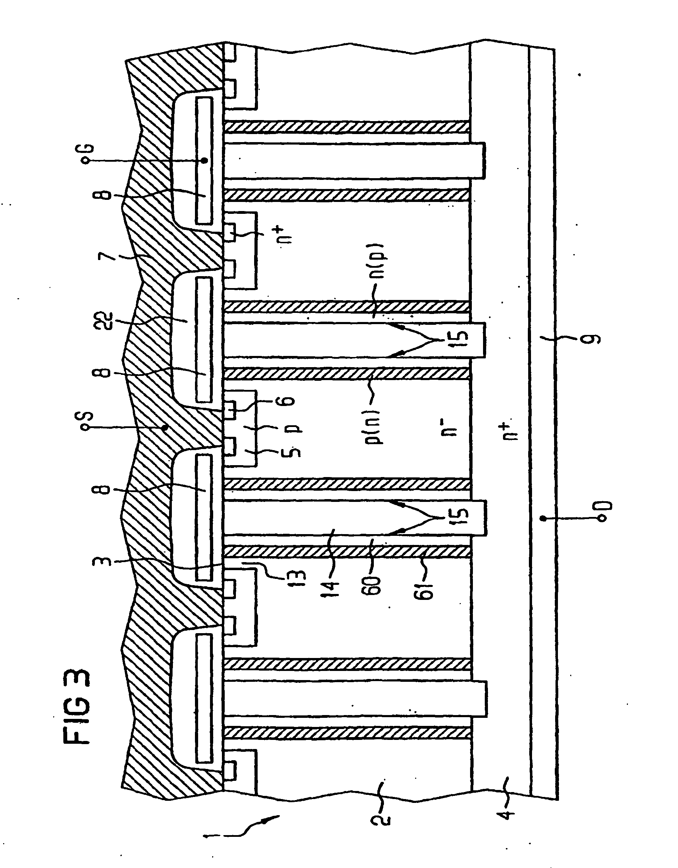

Die Figur 3 zeigt ein weiteres Ausführungsbeispiel eines erfindungsgemäßen V-MOSFETs. Dieser MOSFET unterscheidet sich von den in den Figuren 1 bzw. 2 gezeigten in der Ausgestaltung der Innenzone 2. Unterhalb der durch Gateoxid 22 isolierten Gateelektroden 8 erstrecken sich hier von der sourceseitigen Oberfläche 3 der Innenzone 2 bis in die Drainzone 4 hinein im Bereich der Zwischenzellenzonen 13 vertikale Gräben 14. Diese Gräben 14 sind teilweise oder vollständig mit isolierendem Material, z.B. Siliziumoxid und/oder schwach dotiertem Polysilizium aufgefüllt. Auch eine Kombination von mehreren übereinanderliegenden Isolationsschichten mit dazwischenliegenden schwach dotiertem Polysilizium ist möglich.

Die so mit isolierendem Material aufgefüllten Gräben 14 sind von der Innenzone 2 über eine n-dotierte Komplementärausräumzone 61 getrennt, welche mit einer p-dotierten Ausräumzone 60 versehen ist. Die so von den Ausräumzonen 60 und Komplementärausräumzonen 61 erzeugten Grabenumhüllungen sind in ihrer Dotierung dabei so bemessen, daß bei einer U_{D}-Spannung, welche kleiner als die Durchbruchspannung zwischen den Ausräumzonen 60 und Komplementärausräumzonen 61 ist, die Ausräumzone 60 und die Komplementärausräumzone 61 nahezu vollkommen ausgeräumt werden.

Der Querschnitt der Gräben 14 kann rund, streifenförmig oder beliebig sein. Die Gräben 14 müssen sich dabei nicht bis in die Drainzone 4 erstrecken, vielmehr ist der Tiefenverlauf frei wählbar. Wird z.B. ein runder Grabenquerschnitt gewählt, so erhalten die den mit isolierendem Material aufgefüllten Graben 14 umhüllenden Ausräumzonen 60 und Komplementärausräumzonen 61 eine quasi zylindrische Form.

Die Reihenfolge der Dotierung der Ausräumzonen 60 und Komplementärausräumzonen 61 zwischen der Innenzone 2 und dem Graben 14 ist dabei beliebig, d.h. die Komplementärausräumzone 60 kann sowohl zwischen Graben 14 und Komplementärausräumzone 61 als auch zwischen Komplementärausräumzone 61 und Innenzone 2 angeordnet sein.

Ferner ist es auch möglich, nur einen Teil der Grabenwände 15 mit Ausräumzonen 60 und Komplementärausräumzonen 61 zu belegen.

Die Figur 4 zeigt ein weiteres Ausführungsbeispiel entsprechend der in Figur 3 dargestellten Anordnung. Der Unterschied zur Anordnung gemäß Figur 3 besteht in der Ausgestaltung der Gateelektrode. Im Gegensatz zu der in Figur 3 dargestellten Anordnung ist hier die Gateelektrode zweigeteilt bzw. weist eine Gateaussparung 19 auf, die die Gateelektrode in einen ersten Teilbereich 17 und einen zweiten Teilbereich 18 aufteilt. Sinn dieser Anordnung ist, daß durch eine so ausgebildete Gateelektrode der darunter befindliche Graben 14 maskiert wird. Dadurch kann ein vereinfachtes Herstellverfahren des Grabens 14 erzielt werden. Wie bei bekannten Strukturen, bei denen das Gate zur Maskierung bestimmter Bereiche während des Herstellverfahrens dient, wird hier durch die Form des Gates die Ausbildung des Grabens 14 entsprechend der Formgebung der Gateaussparung 19 eingestellt.

Figur 5 zeigt ein weiteres Ausführungsbeispiel eines vertikalen MOSFETs. Der hier gezeigte V-MOSFET entspricht ebenfalls im wesentlichen der in Figur 3 wiedergegebenen Struktur mit dem Unterschied, daß der Graben 14' hier als annähernd V-förmiger Graben ausgebildet ist. Dementsprechend sind auch die Ausräumzonen und Komplementärausräumzonen V-förmig ausgebildet. Ebenso ist es jedoch auch denkbar, den Scheitel bzw. Umkehrpunkt des Grabens 14' U-förmig auszubilden. Ein derartiger Trench-V-MOSFET ist leicht herstellbar, wenn die Gräben wie in Figur 5 dargestellt, V-förmig ausgebildet sind, wobei ein sehr kleiner Winkel Φ, vorzugsweise 5° bis 10° verwendet wird. Dann können die Grabenwände 15' durch Ionenimplantation mit einem Einfallswinkel von 0° mit hoher Genauigkeit und Gleichmäßigkeit belegt werden. Die unterschiedlichen Dotierungen der Ausräumzonen und Komplementärausräumzonen können aus der Grabenwand durch eine oder mehrere Hochtemperaturbehandlungen in das einkristalline Silizium der Drainzone 4 und der Innenzone 2 eingetrieben werden. Es ist hier auch denkbar, daß jeweils nur eine Grabenseitenwand mit einer Ausräumzone bzw. einer Komplementärausräumzone belegt wird.

Figur 6 zeigt ein nicht erfindungsgemäßes Ausführungsbeispiel, welches einen lateralen MOSFET darstellt. Wie aus der Figur 6 ersichtlich ist, besteht der laterale MOSFET aus einem Halbleiterkörper 1 mit einer p-dotierten Innenzone 2. In die p-dotierte Innenzone 2 ist auf deren Oberfläche 3 eine n-dotierte Sourcezone 6 eingebracht. In der n-dotierten Sourcezone 6 befindet sich eine Sourceelektrode 7 aus Metallsilizid, welche mit einem Sourceanschluß S verbunden ist. Ferner ist eine ebenfalls n-dotierte Drainzone 4 in die Oberfläche 3 des Halbleiterkörpers 1 eingebracht. Die n-dotierte Drainzone 4 weist wiederum eine Drainelektrode 9 aus Metallsilizid auf, die einen Drainanschluß D aufweist. Zwischen Sourcezone 6 und Drainzone 4 befindet sich eine Driftzone 12, die schwach n-dotiert ist. In diese Driftzone 12 sind wiederum Ausräumzonen 10 eingebracht, die p-dotiert sind. Der Abstand der einzelnen p-dotierten Ausräumzonen 10 zueinander ist vorzugsweise wiederum kleiner als die Breite der Raumladungszone zwischen der eingebrachten p-dotierten Ausräumzonen 10 und der schwach n-dotierten Driftzone 12. Auch hier ist die Gesamtmenge der Dotierungen in den verteilten p-dotierten Ausräumzonen 10 in etwa gleich mit der Gesamtmenge der Dotierungen in der schwach n-dotierten Driftzone 12.

Über dem Halbleiterkörper befindet sich in bekannter Weise eine Gateelektrode 8, die gegenüber dem gesamten Halbleiterkörper 1 über ein Gateoxid 22 isoliert ist. Die Gateelektrode 8 kann auch in bekannter Weise so ausgestaltet werden, daß der Abstand zwischen der Gateelektrode 8 und der p-dotierten Innenzone 2 von der Sourcezone 6 in Richtung der Drainzone 4 zunimmt.

Die Funktionsweise einer derartigen lateralen Struktur wird im folgenden näher erläutert. Bei kleiner Drainspannung ist die Leitfähigkeit gut, da die n-dotierte Driftzone 12 niederohmig ist. Wird die Drainspannung moderat erhöht, so räumen sich die Ausräumzonen 10 und die Driftzone 12 gegenseitig aus. Bei einer weiteren Spannungserhöhung wird nun die laterale Feldstärke derart erhöht, daß das ganze Volumen der Driftzone 12 ausgeräumt wird. Der zwischen der Driftzone 12 und der Sourcezone 6 liegende Bereich der Innenzone 2 nimmt dann die weitere Spannung auf.

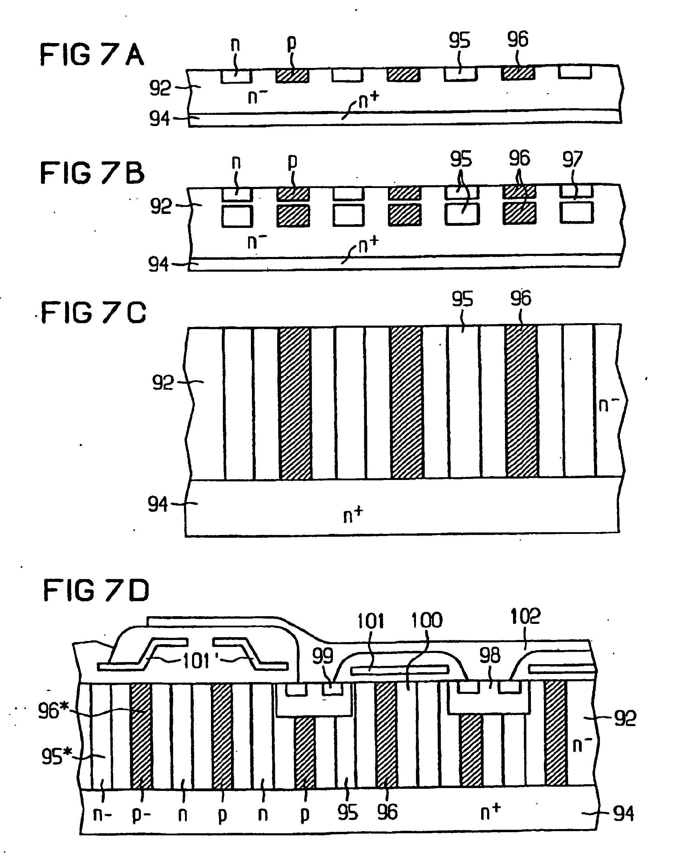

Die Figuren 7a bis 7d zeigen ein mögliches Herstellverfahren für ein vertikales Halbleiterbauelement gemäß der vorliegenden Erfindung. Auf einem n⁺-dotierten Substrat 94 wird eine erste dünne n⁻-dotierte Schicht 92 epitaktisch aufgewachsen. Diese wird beispielsweise durch entsprechende Maskierung und Ionenimplantation mit sich abwechselnden n-dotierten bzw. p-dotierten Bereichen 95, 96 dotiert. Die Dotierung kann selbstverständlich auch durch andere bekannte Verfahren erfolgen.

Danach wird, wie in Figur 7b zu sehen ist, eine weitere n⁻dotierte Schicht 97 epitaktisch aufgebracht. Durch Wiederholen dieses Schrittes wird durch eine mehrstufige Epitaxieabscheidung schließlich die n⁻-dotierte Zone 92 bis zu den noch einzubringenden Basiszonen 98 vervollständigt.

Je nach verwendeten Masken können pro Schicht die unter-schiedlichsten Strukturen gebildet werden. Die Dotierungen der Ausräumzonen 96 und Komplementärausräumzonen 95 können z.B. derart gewählt werden, daß sich die einzelnen Ausräumzonen 96 und Komplementärausräumzonen 95 einer Schicht nach einer Hochtemperaturbehandlung mit denjenigen der darunterliegenden Schicht verbinden, so daß sich insgesamt, wie in Figur 7c dargestellt, streifenförmige Ausräumzonen 96 und streifenförmige Komplementärausräumzonen 95 ausbilden. Die in den einzelnen Schichten dotierten Ausräumzonen 96 und Komplementärausräumzonen 95 können jedoch auch voneinander getrennt sein, wie es in den Bereichen A und C in den in der Figur 1 dargestellt ist. Durch entsprechende Wahl der Masken können auch statistische räumliche Verteilungen der einzelnen Gebiete erreicht werden.

Schließlich werden die Basiszonen 98 und die Sourcezonen 99 eine weitere aufgebrachte Epitaxieschicht eingebracht und in den übrigen Bereiche kann z.B. eine weitere Dotierung von Ausräumzonen und Komplementärausräumzonen erfolgen, so daß sich die streifenförmigen Ausräumzonen 96 und Komplementärausräumzonen 95 in den Zwischenzellenzonen 100 bis zur Oberfläche erstrecken.

Die am Randbereich eingebrachten Ausräumzonen und Komplementärausräumzonen in Figur 7d sind mit 96* und 95* bezeichnet. Diese am Rand liegenden Ausräumzonen 96* und Komplementärausräumzonen 95* werden schwächer als die im Inneren des Halbleiterkörpers liegenden übrigen Ausräumzonen 96 und Komplementärausräumzonen 95 dotiert. Es folgen nun weitere Schritte zur Aufbringung der Gateelektrode 101 bzw. der Randgateelektrode 101' und der Sourceelektrode 102 in bekannter Weise.

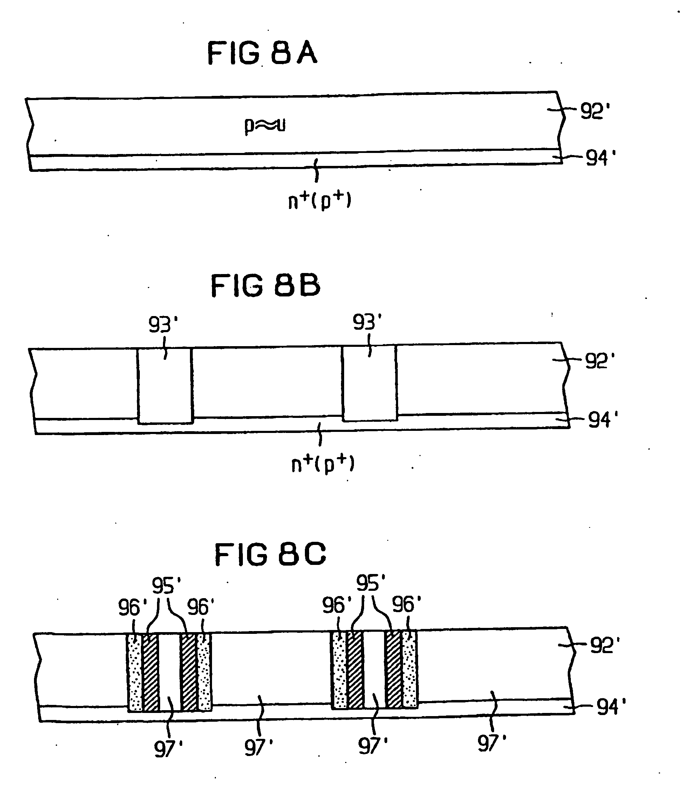

In den Figuren 8a bis 8c wird ein weiteres verbessertes Verfahren zur Herstellung eines vertikalen durch Feldeffekt steuerbaren Halbleiterbauelements gemäß der vorliegenden Erfindung gezeigt. Dort geschieht das Einbringen der Ausräumzonen 96' und Komplementärausräumzonen 95' über den Umweg einer ersten speziellen epitaktisch abgeschiedenen Schicht. Auf einem Substrat 94' wird eine erste Epitaxieschicht 92' aufgebracht, die gleichzeitig p-Dotierstoffe und n-Dotierstoffe in etwa gleichen Mengen enthält. Dabei sind die Dotierstoffe so gewählt werden, daß die Diffusionskoeffizienten der beiden Dotierelemente sich deutlich voneinander unterscheiden. Besonders geeignet sind als p-Dotierstoff Bor und als n-Dotierstoff Arsen, da der Diffusionskoeffizient von Arsen etwa 10 mal größer ist als der von Bor.

Danach werden Gräben 93' in den gewünschten geometrischen Ausmaßen in diese erste Epitaxieschicht 92' geätzt, wobei es auf eine extrem gute Reproduzierbarkeit bei diesem Schritt nicht ankommt.

Danach werden die Gräben 93' mit einer zweiten hochohmigen Epitaxieschicht 97' aufgefüllt, wobei diese zweite Epitaxieschicht 97' den Graben in der Weise ausfüllt, daß keinerlei Kristallstörungen auftreten. Dies ist in Figur 8b veranschaulicht.

Schließlich wird der so prozessierte Halbleiterkörper danach einem Temperaturschritt unterworfen, bei dem die beiden unterschiedlich schnell diffundierenden Elemente der ersten Epitaxieschicht 92', z.B. also die Dotierstoffe Arsen und Bor, in die zweite Epitaxieschicht 97' eindiffundieren können. Aufgrund des unterschiedlichen Diffusionskoeffizienten reichert sich der besser diffundierende Dotierstoff, im vorliegenden Beispiel Bor, in der zweiten Epitaxieschicht 97' an, während der schlechter diffundierende Dotierstoff, im vorliegenden Beispiel Arsen, in der ersten Epitaxieschicht 92' am Rand zum Graben überwiegt.

Nach diesem Temperschritt, der auch mit den nachfolgenden Schritten des Herstellungsprozesses für das zu fertigende Halbleiterbauelement kombiniert werden kann, ist am Rande des Grabens jeweils eine Ausräumschicht 96' und eine Komplementärausräumschicht 95' vorhanden. Die Gesamtmenge von p-Dotierung bzw. n-Dotierung ist somit immer etwa gleich groß, da die ursprünglich eingebrachte Dotierung durch den beschriebenen Prozeß nun anders verteilt wird. Der Prozeß ist demnach quasi selbstjustierend.

Die Einbringung der Basiszonen, Sourcezonen, sowie die Aufbringung der Gateelektrode und die Ausbildung der Randbereiche erfolgt analog zu dem Verfahren, das oben beschrieben wurde.

Die in den Figuren 7 und 8 gezeigten Verfahren lassen sich leicht zur Herstellung von lateralen MOSFETs modifizieren.

Zusammenfassend läßt sich sagen, daß durch die vorliegende Erfindung vertikale MOSFETs sowie IGBTs mit niedrigem Durchlaßwiderstand Rₒₙ bei gleichzeitig hoher Sperrspannung vorgesehen werden können. Wesentlich ist die Ausbildung von paarweisen p- bzw. n-dotierten Bereichen, welche strukturiert oder statistisch eingebracht sind, wobei vorzugsweise streifenförmige Bereiche vorgesehen sind, die entlang des Strompfades der Laststrecke ausgebildet sind. Die vorliegende Erfindung ist dabei sowohl bei MOSFETs vom p-Kanal wie auch bei MOSFETs vom n-Kanal oder auch entsprechenden IGBTs anwendbar.

### Bezugszeichenliste

- 1 =: Halbleiterkörper
- 2 =: Innenzone
- 3 =: sourceseitige Oberfläche
- 4 =: Drainzone
- 5 =: Basiszone
- 6 =: Sourcezone
- 7 =: Sourceelektrode
- 8 =: Gateelektrode
- 9 =: Drainelektrode
- 10 =: Ausräumzone
- 11 =: Komplementärausräumzone
- 12 =: Driftzone
- 13 =: Zwischenzellenzone
- 14 =: Graben
- 15 =: Grabenwand
- 16 =: drainseitige Oberfläche
- 17 =: Gateaussparung
- 18 =: erster Gatebereich
- 19 =: zweiter Gatebereich
- 20, 30, 40, 50, 60, 70 =: Ausräumzone
- 21, 31, 41, 51, 61, 71 =: Komplementärausräumzone
- 22 =: Gateoxid
- 92 =: erste n⁻-Epitaxieschicht
- 92' =: erste Epitaxieschicht
- 93' =: Graben
- 94 =: n⁺-Substrat
- 94' =: Substrat
- 96 =: p-dotierter Bereich = Ausräumzone
- 96' =: Ausräumschicht
- 96* =: Randausräumzone
- 95 =: n-dotierter Bereich = Komplementärausräumzone
- 95' =: Komplementärausräumschicht
- 95* =: Randkomplementärausräumzone
- 97 =: zweite n⁻-Epitaxieschicht
- 97' =: zweite Epitaxieschicht
- 98 =: Basiszone
- 99 =: Sourcezone
- 100 =: Zwischenzellenzone
- 101 =: Gateelektrode
- 101' =: Randgateelektrode
- 102 =: Sourceelektrode

## Patentansprüche

1. Durch Feldeffekt steuerbares vertikales Halbleiterbauelement bestehend aus einem einen Randbereich aufweisenden Halbleiterkörper (1).
I. mit einer Innenzone (92) vom ersten Leitungstyp, die an eine Oberfläche des Halbleiterkörpers angrenzt,
II. mit einer Drainzone (94), die auf einer Seite an die Innenzone (92) angrenzt und die auf der anderen Seite an die entgegengesetzte Oberfläche des Halbleiterkörpers angrenzt,
III. mit mindestens einer Basiszone (98) vom zweiten Leitungstyp, die an der Oberfläche in den Halbleiterkörper eingebettet ist,
IV. mit mindestens einer Sourcezone (99) vom ersten Leitungstyp, die jeweils in die Basiszone (98) an der Oberfläche eingebettet ist,
V. mit mindestens einer Sourceelektrode (102) die jeweils mindestens eine Basiszone (98) und die darin eingebettete Sourcezone (99) kontaktiert, und
VI. mit mindestens einer gegen den gesamten Halbleiterkörper und gegen die Sourceelektrode (102) isolierten Gateelektrode (101),
VII. mit mindestens einer Ausräumzone (96) vom zweiten Leitungstyp in der Innenzone (92),
VIII. mit mindestens einer Komplementärausräumzone (95) vom ersten Leitungstyp in der Innenzone (92), wobei die Gesamtmenge der Dotierung der Ausräumzonen (96) in etwa der Gesamtmenge der Dotierung der Komplementärausräumzonen (95) entspricht,
IX. **dadurch gekennzeichnet, dass** im Randbereich des Halbleiterkörpers wenigstens eine Ausräumzone (96*) angeordnet ist, die schwächer dotiert ist als die mindestens eine Ausräumzonen (96) in der Innenzone, und im Randbereich wenigstens eine Komplementärausräumzone (95*) angeordnet ist, die schwächer dotiert ist als die mindestens eine Komplementärausräumzone (95) in der Innenzone.

2. Halbleiterbauelement nach Anspruch 1,
**dadurch gekennzeichnet**, dass die Ausräumzonen (96, 96*) und die Komplementärausräumzonen (95, 95*) in der Innenzone (92) jeweils paarweise angeordnet sind.

3. Halbleiterbauelement nach Anspruch 2,
**dadurch gekennzeichnet**, dass die Ausräumzonen (96, 96*) und die Komplementärausräumzonen (95, 95*) sich bis an die Drainzone (94) erstrecken.

4. Halbleiterbauelement nach einem der Ansprüche 1 bis 3,
**dadurch gekennzeichnet**, dass die Ausräumzonen (96, 96*) und/oder die Komplementärausräumzonen (95, 95*) streifenförmig ausgebildet sind.

## Claims

1. Field effect-controllable vertical semiconductor component consisting of a semiconductor body (1) having an edge region,
I. comprising an inner zone (92) of the first conduction type, which adjoins a surface of the semiconductor body,
II. comprising a drain zone (94), which on one side adjoins the inner zone (92) and which on the other side adjoins the opposite surface of the semiconductor body,
III. comprising at least one base zone (98) of the second conduction type, which is embedded into the semiconductor body at the surface,
IV. comprising at least one source zone (99) of the first conduction type, which is embedded in each case into the base zone (98) at the surface, and
V. comprising at least one source electrode (102), which in each case makes contact with at least one base zone (98) and the source zone (99) embedded therein, and
VI. comprising at least one gate electrode (101) which is insulated from the entire semiconductor body and from the source electrode (102),
VII. comprising at least one depletion zone (96) of the second conduction type in the inner zone (92),
VIII. comprising at least one complementary depletion zone (95) of the first conduction type in the inner zone (92), wherein the total amount of the doping of the depletion zones (96) approximately corresponds to the total amount of the doping of the complementary depletion zones (95),
IX. **characterized in that** there is arranged in the edge region of the semiconductor body at least one depletion zone (96*) which is more weakly doped than the at least one depletion zone (96) in the inner zone, and there is arranged in the edge region at least one complementary depletion zone (95*) which is more weakly doped than the at least one complementary depletion zone (95) in the inner zone.

2. Semiconductor component according to Claim 1,
**characterized in that** the depletion zones (96, 96*) and the complementary depletion zones (95, 95*) are arranged in the inner zone (92) in each case in pairs.

3. Semiconductor component according to Claim 2,
**characterized in that** the depletion zones (96, 96*) and the complementary depletion zones (95, 95*) extend as far as the drain zone (94).

4. Semiconductor component according to any of Claims 1 to 3,
**characterized in that** the depletion zones (96, 96*) and/or the complementary depletion zones (95, 95*) are embodied in strip-shaped fashion.

## Revendications

1. Composant à semiconducteur vertical pouvant être commandé par effet de champ et constitué d'un corps (1) semiconducteur ayant une région de bord,
I. ayant une zone (92) intérieure du premier type de conductivité, qui est voisine d'une surface du corps semiconducteur,
II. ayant une zone (94) de drain, qui, d'un côté, est voisine de la zone (92) intérieure et qui, de l'autre côté, est voisine de la surface opposée du corps semiconducteur,
III. ayant au moins une zone (98) de base du deuxième type de conductivité, qui, sur la surface, est incorporée dans le corps semiconducteur,
IV. ayant au moins une zone (99) de source du premier type de conductivité, qui est incorporée sur une surface respectivement dans la zone (98) de base,
V. ayant au moins une électrode (102) de source, qui est en contact respectivement avec au moins une zone (98) de base et avec la zone (99) de source qui y est incorporée, et
VI. ayant au moins une électrode (101) de grille isolée par rapport à tout le corps semiconducteur et par rapport à l'électrode (102) de source,
VII. ayant au moins une zone (96) de déplétion du deuxième type de conductivité dans la zone (92) intérieure,
VIII. ayant au moins une zone (95) de déplétion complémentaire du premier type de conductivité dans la zone (92) intérieure, la quantité totale du dopage des zones (96) de déplétion correspondant à peu près à la quantité totale du dopage des zones (95) de déplétion complémentaire,
IX. **caractérisé en ce que**, dans la région de bord du corps semiconducteur, est disposée au moins une zone (96*) de déplétion, qui est moins dopée que la au moins une zone (96) de déplétion de la zone intérieure, et, dans la région de bord, est disposée au moins une zone (95*) de déplétion complémentaire, qui est moins dopée que la au moins une zone (95) de déplétion complémentaire dans la zone intérieure.

2. Composant à semiconducteur suivant la revendication 1,
**caractérisé en ce que** les zones (96, 96*) de déplétion et les zones (95, 95*) de déplétion complémentaires sont disposées respectivement par paire dans la zone (92) intérieure.

3. Composant à semiconducteur suivant la revendication 2,
**caractérisé en ce que** les zones (96, 96*) de déplétion et les zones (95, 95*) de déplétion complémentaires s'étendent jusqu'à la zone (94) de drain.

4. Composant à semiconducteur suivant l'une des revendications 1 à 3,
**caractérisé en ce que** les zones (96, 96*) de déplétion et/ou les zones (95, 95*) de déplétion complémentaires sont constituées sous la forme de bande.
